# EUROPEAN PATENT APPLICATION

(11) **EP 2 421 194 A1**
(43) Date of publication of application: **22.02.2012**
(21) Application number: 10814759.6
(22) Date of filing: 28.06.2010
(51) Int. Cl.: H04L 12/02, H05K 7/20

(54) **TOTALLY ENCLOSED TYPE INTEGRATED ACCESS SYSTEM AND METHOD OF REDUCING POWER CONSUMPTION OF THE SYSTEM**

(71) Applicant: ZTE Corporation, Shenzhen, Guangdong 518057 (CN)
(72) Inventor: KANG, Jian, Shenzhen, Guangdong 518057 (CN); LI, Gezhong, Shenzhen, Guangdong 518057 (CN); WANG, Xiao, Shenzhen, Guangdong 518057 (CN); ZILBERBERG, José Henrique, CEP-20230-070 Rio de Janeiro, RJ (BR)
(74) Representative: Howson, Richard G.B.
(86) International application number: PCT/CN2010/074644
(87) International publication number: WO 2012/000166

(57) **Abstract**

The present invention provides a totally-enclosed integrative access system, the system adopts a die-cast case that consists of an upper cover and a lower cover, the joint face between the upper cover and the lower cover is sealed, and the peripheries of the upper cover and the lower cover are configured with cooling teeth, heating parts in the system contact closely with the inside wall of the upper cover and/or the lower cover; and the heating parts include: a user panel, a system control panel and a power panel. A power consumption reduction method for a totally-enclosed integrative access system is also provided in the present invention, including: the system control panel detects traffic on the user panel; when the traffic detected is lower than a predefined lower limit value, the system control panel enters a low frequency working mode; when the traffic detected reaches a predefined upper limit value, the system control panel restores its normal working frequency. The present invention solves existing problems with integrative access devices, including loud noise, parts susceptible to damage, inflexible installation and inconvenient engineering maintenance.

## Description

### TECHNICAL FIELD

This present invention relates to an access technology of the telecommunication field, particularly relates to a totally-enclosed integrative access system and a power consumption reduction method thereof.

### BACKGROUND

An integrative access device refers to a device capable of simultaneously accessing broadband services and narrow-band services and with certain characteristics of broadband and narrow-band integration. Wherein the broadband services include: an asymmetric digital subscriber loop (ADSL), an ADSL2+, a very-high-bit-rate digital subscriber loop (VDSL), a VDSL2, an Ethernet and other service; and the narrow-band services include: a public switched telephone network (PSTN), an integrated services digital network (ISDN), a digital data network (DDN) and other service.

The existing integrative access devices all adopt a system manner that incorporates a fan and is non-enclosed. Such a manner features rapid cooling and the powerful capability of devices to resist high temperature. However, the shortcomings of the system manner are obvious: firstly noise from a fan is loud, consequently greatly influencing the residential environment of residences when the fan is placed nearby a corridor of residents; secondly, as the fan is a mechanical device, the device is susceptible to damage due to factors, e.g. dust, consequently resulting in undesirable system cooling and burnout of system parts due to high temperature; thirdly, installation locations are inflexible, devices are required to be put inside special cabinets when installed on wire poles, and can not be installed in underground pipes; fourthly, engineering maintenance is inconvenient, as all devices are realized by using a system consisting of individual independent single boards, maintenance personnel have to identify which single board fails in case of failure before replacing the related single board, which requires rather higher technical level of the maintenance personnel and costs longer time for removing the failure.

### SUMMARY

In view of this, the purpose of the present invention is to provide a totally-enclosed integrative access system and a power consumption reduction method thereof to solve the existing problems with integrative access devices, including loud noise, parts susceptible to damage, inflexible installation and inconvenient engineering maintenance.

To achieve the above-mentioned purposes, the present invention realizes its technical scheme in the following way.

The present invention provides a totally-enclosed integrative access system, the system adopts a die-cast case which may consist of an upper cover and a lower cover, the joint face between the upper cover and the lower cover may be sealed, and the peripheries of the upper cover and the lower cover may be configured with cooling teeth respectively, and heating parts in the system may contact closely with the inside wall of the upper cover and/or the lower cover.

The heating parts may include: a user panel, a system control panel and a power panel.

The die-cast case may have external interfaces, and the interface may adopt a mode in which it is a dismountable connector.

The joint face between the lower cover and the upper cover may be provided with a groove, and the groove may be internally configured with a seal; when the upper cover is installed together with the lower cover, the seal may seal the joint face between the upper cover and the lower cover.

The user panel, the system control panel and the power panel may be interconnected with connectors and cables, and motherboards and sub-boards in the user panel, system control panel and power panel may be hard wired with each other.

The die-cast case may be provided with a handle.

The present invention also provides a power consumption reduction method for the totally-enclosed integrative access system. The system may adopt a die-cast case which may consist of an upper cover and a lower cover, the joint face between the upper cover and the lower cover may be sealed, and the peripheries of the upper cover and the lower cover may be configured with cooling teeth, and heating parts in the system may contact closely with the inside wall of the upper cover and/or the lower cover. The heating parts may include: a user panel, a system control panel and a power panel. The method includes:
the system control panel detects traffic on the user panel, when the traffic detected is lower than a predefined lower limit value, the system control panel enters a low-frequency working mode; and subsequently, when the traffic detected reaches a predefined upper limit value, the system control panel restores its normal working frequency.

This method may further include: when a narrow-band user panel is detected not working, the system control panel only reserves operation of a module for detecting off-hook of narrow-band users, and closes other modules related to narrow-band users.

The other modules related to narrow-band users may include: an analog-digital conversion module, a conversion module from time-division switching to packet switching, and a ringing current module.

Accordingly, after closing the other modules related to narrow-band users, the method may further include: if the system control panel detects call access, then the ringing current module will be restarted; if the system control panel detects user off-hook, then the analog-digital conversion module will be restarted; if the system control panel detects call through, then the conversion module from time-division switching to packet switching will be restarted.

The method may further include: when a broadband user panel is detected not working, the system control panel only reserves operation of a module for detecting whether broadband users set up links, and closes other modules related to broadband users.

The other modules related to broadband users may include a packet processing and packet switching module.

Accordingly, after the other modules related to broadband users are enclosed, the method may further include: if the system control panel detects there is a user setting up a link, the packet processing and packet switching module will be restarted.

The present invention provides a totally-enclosed integrative access system, the system adopts a die-cast case which may consist of an upper cover and a lower cover, and the joint face between the upper cover and the lower cover may be sealed, and the peripheries of the upper cover and the lower cover may be configured with cooling teeth, and heating parts in the system may contact closely with the inside wall of the upper cover and/or the lower cover. The heating parts may include: a user panel, a system control panel and a power panel.

The present invention realizes a totally-enclosed integrative access system. The system features no fan, a totally-enclosed design and integration. Due to no noise, the system can be installed at places such as a residence corridor but impose no impact on residential environments of residences; due to no fan, the probability of damage to device hardware is greatly reduced; due to the integrated totally-enclosed design, the system can be individually installed in many types of complex environments, e.g. on a wire pole, in a sewer and on a wall, etc.; due to the integrated structure, a device installer can directly take a device to a desired place for installation, and the maintenance personnel can directly replace an old device with a new device in case of device failure, and consequently it requires lower technical requirements for maintenance personnel, and the failure can be removed within a very short time.

The present invention also offers a power consumption reduction method for the totally-enclosed integrative access system, which includes: the system control panel detects traffic on the user panel, when the traffic detected is lower than a predefined lower limit value, the system control panel enters a low-frequency working mode; and subsequently, when the traffic detected reaches a predefined upper limit value, the system control panel restores its normal working frequency. The power consumption reduction method of the present invention effectively lowers heating value of heating parts inside the system and is more propitious to controlling temperature inside the system, and greatly reduces the probability of damage to device hardware.

### BRIEF DESCRIPTION OF THE DRAWINGS

Fig.1 is structural schematic diagram 1 of a totally-enclosed integrative access system of the present invention;
Fig.2 is structural schematic diagram 2 of a totally-enclosed integrative access system of the present invention;
Fig.3 is structural schematic diagram 3 of a totally-enclosed integrative access system of the present invention; and
Fig.4 is a flow chart of a power consumption reduction method for the totally-enclosed integrative access system of the present invention.

### DETAILED DESCRIPTION

The technical scheme of the present invention will be further described in detail in combination with the drawings and specific embodiments.

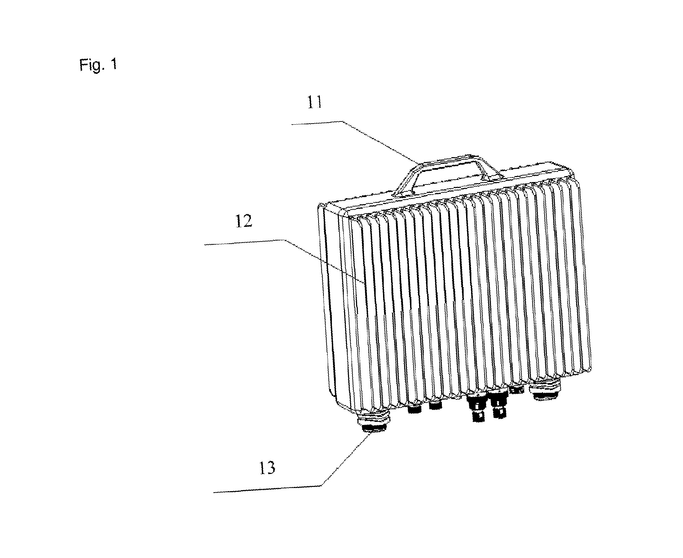

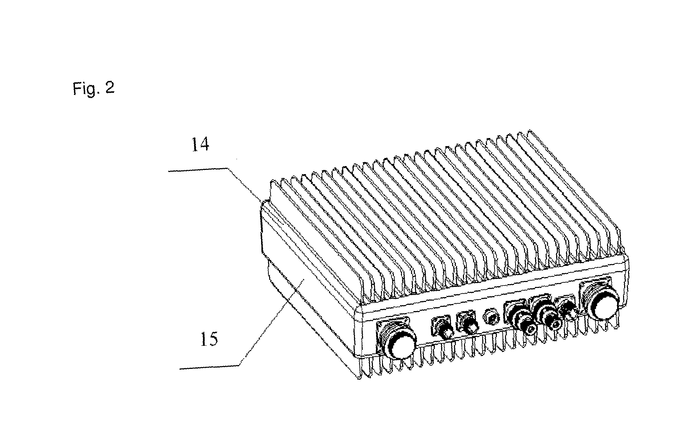

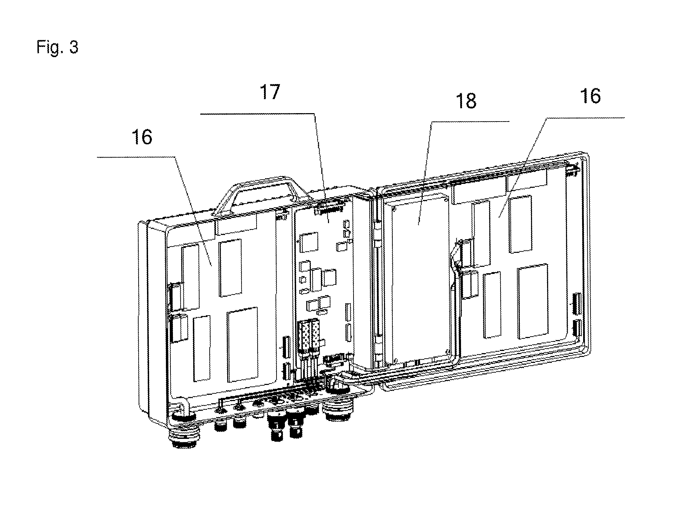

The present invention provides a totally-enclosed integrative access system to solve the existing problems with integrative access devices, including loud noise, parts susceptible to damage, inflexible installation and inconvenient engineering maintenance. Fig.1 illustrates the front structure of the system, Fig.2 illustrates the side structure of the system, and Fig.3 illustrates the internal structure of the system.

The system adopts a die-cast case design, and for a system with small capacity and lower heating value, a case design of steel plate welding forming can also be used. The case consists of an upper cover 14 and a lower cover 15, and the joint face between the upper cover 14 and the lower cover 15 is sealed, and the periphery of the upper cover 14 and that of the lower cover 15 are provided respectively with cooling teeth 12; heating parts in the system require close contact with the inside wall of the upper cover 14 and/or the lower cover 15, in such way, the heat generated from the heating parts transfers to the case encloser via the upper cover 14 and/or the lower cover 15, and then diffuses into the air through cooling teeth 12.

After installation of the upper cover 14 and the lower cover 15, the case internal should have proper sealing performance, usually being airtight, which can effectively protect the parts inside the system. In the present invention, the joint face between the lower cover 15 and the upper cover 14 is provided with a groove, and the groove is internally built with a seal; when the upper cover 14 is installed together with the lower cover 15, the seal seals the joint face between the upper cover 14 and the lower cover 15 so that the case internal has good sealing performance.

The die-cast case is provided with external interfaces 13, and the external interfaces 13 adopt a mode in which they are dismountable connectors. The connectors are all used outdoors specifically, and can satisfy the sealing properties of the outdoors, and the sealing performance in practical use can reach at least IP67. Wherein the external interfaces 13 on the die-cast case can have many types, e.g.: a multi-core user wire connector, a fiber connector, an RJ45 connector, a power connector, an E1 connectors, etc..

The heating parts inside the case mainly include: a user panel 16, a system control panel 17 and a power panel 18. The user panel 16, the system control panel 17 and the power panel 18 are interconnected with connectors and cables, and motherboards and sub-boards in these user panel 16, system control panel 17 and power panel 18 are hard wired with each other. To ensure the efficiency of heat conduction, all heating chips on single boards are required to contact closely with the inside wall of the case, and the parts not generating heat can be arranged on the side not contacting the case. Wherein the system control panel 17 is used to realize interconnection between protocol and network administrator, and to coordinate and control the work on remaining single boards inside the system, and the time-division switching network and packet switching network are both realized on the system control panel 17. The user panel 16 includes: a narrow-band user panel and a broadband user panel, and one or more pieces of user panels 16 can be provided to realize broadband service access or narrow-band service access, and certainly, broadband service access and narrow-band service access can be realized simultaneously. The power panel 18 is responsible for handling AC power and DC power access, and then provides outputs of many types of power, e.g. 5V, 3.3V and 48V, to the system control panel 17 and the user panel 16 for use.

Common user panels 16 includes: an ADSL single board, an ADSL2+single board, a VDSL single board, a VDSL2 single board, a Plain Old Telephone Service (POTS) single board, an Ethernet single board, and a single board integrating DSL and POTS. The functions supported by the system of the present invention mainly include:
supporting ADSL/ADSL2+access function;
supporting VDSL/VDSL2 access function;
supporting POTS voice access function;
supporting E1 downlink;
supporting ISDN access function;
supporting 100M Ethernet downlink;
supporting a downlink Ethernet Passive Optical Network (EPON) and Gigabit-Capable Passive Optical Network (GPON) interfaces;
supporting E1 uplink;
supporting 100M and giga Ethernet uplink;
supporting EPON and GPON uplink;
supporting AC power input, DC power input, and optical fiber remote power supply and twisted-pair cable remote power supply;
supporting multiple protocols such as V5, H.248, Session Initiation Protocol (SIP), IP Multimedia Subsystem (IMS) SIP, Primary Rate Interface (PRI), Basic Rate Interface (BRI), R2, Virtual Local Area Network (VLAN), Address Resolution Protocol (ARP), Internet Group Management Protocol (IGMP), Spanning Tree Protocol (STP), Multiple Spanning Tree Protocol (MSTP), trunking, and Simple Network Management Protocol (SNMP); and
supporting on-line upgrade, dynamic data configuration and other functions.

In addition, the case can be designed with a handle 11, so that the integrative access system can be carried with hand for installation and portage.

Given above, the system of the present invention features no fan, a totally-enclosed design and integration. Due to no noise, the system can be installed at places such as residence corridors but impose no impact on residential environments of residences; due to no fan, the probability of damage to device hardware is greatly reduced; due to the integrated totally-enclosed design, the system can be individually installed in many types of complex environments, e.g. on a wire pole, in a sewer and on a wall; due to the integrated structure, the device installer can directly take the device to a desired place for installation, and the maintenance personnel can directly replace an old device with a new device in case of device failure, and consequently the technical requirements for the maintenance personnel becomes lower, and the failure can be removed within a very short time.

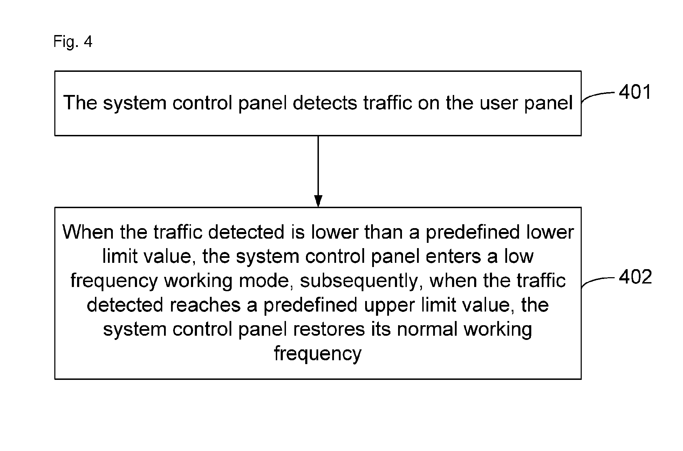

On the basis of the full-enclosed integrative access system, the present invention also provides a power consumption reduction method for the totally-enclosed integrative access system, which adopts a method that corresponding user processing hardware parts do not work when a user does not work, to further reduce the power consumption and heating value inside the system. As shown in Fig.4, the method of the present invention mainly includes the following steps:
Step 401, the system control panel 17 detects traffic on the user panel 16;
Step 402, when the traffic detected is lower than a predefined lower limit value (e.g. 20%), the system control panel 17 enters a low frequency working mode (e.g. the working frequency is 50% of the normal working frequency), subsequently, when the traffic detected reaches a predefined upper limit value (e.g. 30%), the system control panel 17 restores its normal working frequency.

Furthermore, when the narrow-band user panel is detected not working, the system control panel 17 only reserves operation of a module for detecting off-hook of narrow-band users, and closes other modules related to narrow-band users. The other modules related to narrow-band users include: an analog-digital conversion module, a conversion module from time-division switching to packet switching, and a ringing current module; accordingly, after closing the other modules related to narrow-band users, this method further includes: if the system control panel 17 detects call access, the ringing current module will be restarted; if the system control panel 17 detects user off-hook, the analog-digital conversion module will be restarted; if the system control panel 17 detects call through, then the conversion module from time-division switching to packet switching will be restarted.

Furthermore, when the broadband user panel is detected not working, the system control panel 17 only reserves operation of a module for detecting whether broadband users set up links, and closes other modules related to broadband users. The other modules related to broadband users include: a packet processing and packet switching module; accordingly, after the other modules related to broadband users are closed, if the system control panel detects there is a user setting up a link, the packet processing and packet switching module will be restarted.

It can be seen that the power consumption reduction method of the present invention can effectively reduce the heating value of heating parts inside the system, can be more propitious to controlling the temperature inside the system, so that the probability of damage to device hardware is greatly lowered.

The above description is only preferred embodiments of the present invention and is not used to limit the protection scope of the present invention.

## Claims

1. A totally-enclosed integrative access system, the system adopting a die-cast case that consists of an upper cover and a lower cover, the joint face between the upper cover and the lower cover being sealed, and the peripheries of the upper cover and the lower cover are configured with cooling teeth, and heating parts in the system contacting closely with the inside wall of the upper cover and/or the lower cover;
the heating parts including: a user panel, a system control panel and a power panel.

2. The totally-enclosed integrative access system according to claim 1, wherein the die-cast case has external interfaces, and the external interfaces adopt a mode in which they are dismountable connectors.

3. The totally-enclosed integrative access system according to claim 1 or claim 2, wherein the joint face between the lower cover and the upper cover is provided with a groove, and the groove is internally built with a seal; when the upper cover is installed together with the lower cover, the seal seals the joint face between the upper cover and the lower cover.

4. The totally-enclosed integrative access system according to claim 1 or claim 2, wherein the user panel, the system control panel and the power panel are interconnected with connectors and cables, and motherboards and sub-boards in the user panel, system control panel and power panel are hard wired with each other.

5. The totally-enclosed integrative access system according to claim 1 or claim 2, wherein the die-cast case is installed with a handle.

6. A power consumption reduction method for a totally-enclosed integrative access system, the system adopting a die-cast case, and the case consisting of an upper cover and a lower cover, the joint face between the upper cover and the lower cover being sealed, and the peripheries of the upper cover and the lower cover being configured with cooling teeth, heating parts in the system contacting closely with the inside wall of the upper cover and/or the lower cover, and the heating parts including a user panel, a system control panel and a power panel; the method including:
the system control panel detecting traffic on the user panel; when the traffic detected is lower than a predefined lower limit value, the system control panel entering a low frequency working mode, subsequently, when the traffic detected reaching a predefined upper limit value, the system control panel restoring its normal working frequency.

7. The power consumption reduction method for a totally-enclosed integrative access system according to claim 6, the method further including: when a narrow-band user panel is detected not working, the system control panel only reserving operation of a module for detecting off-hook of narrow-band users, and closing other modules related to narrow-band users.

8. The power consumption reduction method for a totally-enclosed integrative access system according to claim 7, wherein the other modules related to narrow-band users include: an analog-digital conversion module, a conversion module from time-division switching to packet switching, and a ringing current module;
accordingly, after closing the other modules related to narrow-band users, the method further including: if the system control panel detects call access, restarting the ringing current module; if the system control panel detects user off-hook, restarting the analog-digital conversion module; if the system control panel detects call through, then restarting the conversion module from time-division switching to packet switching.

9. The power consumption reduction method for a totally-enclosed integrative access system according to claim 6, the method further including: when a broadband user panel is detected not working, the system control panel only reserving operation of a module for detecting whether broadband users set up links, and closing other modules related to broadband users.

10. The power consumption reduction method for a totally-enclosed integrative access system according to claim 9, wherein the other modules related to broadband users include: a packet processing and packet switching module;
accordingly, after the other modules related to broadband users are closed, the method further including: if the system control panel detects there is a user setting up a link, restarting the packet processing and packet switching module.
